(19) Europäisches Patentamt
European Patent Office
Office européen des brevets

(11) **EP 3 935 398 B1**

(12) **EUROPEAN PATENT SPECIFICATION**

(45) Date of publication and mention of the grant of the patent:
**08.05.2024 Bulletin 2024/19**

(21) Application number: **19711231.1**

(22) Date of filing: **08.03.2019**

(51) International Patent Classification (IPC):
***G01R 31/367*** (2019.01)  ***G01R 31/379*** (2019.01)
***G01R 31/3835*** (2019.01)  ***G01R 31/3828*** (2019.01)

(52) Cooperative Patent Classification (CPC):
**G01R 31/367; G01R 31/379; G01R 31/3828; G01R 31/3835**

(86) International application number:
**PCT/EP2019/055851**

(87) International publication number:
**WO 2020/182276 (17.09.2020 Gazette 2020/38)**

(54) **METHOD FOR ESTIMATING THE STATE OF CHARGE SOC OF A BATTERY ASSEMBLY, CORRESPONDING APPARATUS FOR ESTIMATING THE STATE OF CHARGE OF A BATTERY ASSEMBLY AND CORRESPONDING COMPUTER PROGRAM**

VERFAHREN ZUR SCHÄTZUNG DES LADEZUSTANDES EINER BATTERIEANORDNUNG, ENTSPRECHENDE VORRICHTUNG ZUR SCHÄTZUNG DES LADEZUSTANDES EINER BATTERIEANORDNUNG UND ENTSPRECHENDES COMPUTERPROGRAMM

PROCÉDÉ D'ESTIMATION DE L'ÉTAT DE CHARGE SOC D'UN ENSEMBLE BATTERIE, APPAREIL CORRESPONDANT D'ESTIMATION DE L'ÉTAT DE CHARGE D'UN ENSEMBLE BATTERIE ET PROGRAMME INFORMATIQUE CORRESPONDANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**12.01.2022 Bulletin 2022/02**

(73) Proprietor: **Hochschule Anhalt**
**06366 Köthen (DE)**

(72) Inventors:
• **BIKBULATOV, Aleksandr**
  **06366 Köthen (DE)**

• **CHMIELEWSKI, Ingo**
  **38176 Wendeburg (DE)**
• **SIEMENS, Eduard**
  **31319 Sehnde (DE)**

(74) Representative: **Schäferjohann, Volker**
**Obere Mark 13**
**30890 Barsinghausen (DE)**

(56) References cited:
**US-A1- 2010 007 309    US-A1- 2013 110 428**

**EP 3 935 398 B1**

**Description**

The present disclosure relates to the field of vented and valve regulated lead-acid battery maintenance, more particularly, it relates to the determination of the battery condition and its state of charge during its operation, preferably in decentral and energy-autarkic systems. This proposal is part of an overall energy management system for decentral energy-autarkic systems, preferably comprising a renewable energy source like photovoltaic, wind energy or micro-hydro power stations. It is noted that the term battery when it is used in this document means a rechargeable battery. More in particular, the type of vented and valve regulated lead-acid batteries is in particular focus, here.

The valve regulated lead-acid battery type is hereinafter referred to be a VRLA battery. Since these VRLA batteries undergo an aging effect during their operation, when they are charged and discharged numerously, it is important to know their state of health (SOH) to treat them accordingly. It is noted, that the aging effect can be quantified with the SOH parameter. Of course the aging effect does have an influence on different parameters of the battery (e.g. internal resistance, total capacity, open-circuit (OCV), etc.) which are changing over time. The state of health is a parameter that reflects the general condition of a battery and its ability to deliver the specified performance compared with a fresh battery. This corresponds to a long term capability of the battery. State of charge (SOC) in comparison is used to indicate the battery condition at a present time moment due to a discharge/charge process in the energy system. In particular for battery maintenance it is important to know about the SOC and SOH parameter in order to be able to decide if the battery needs to be recharged or replaced (in case of a complete discharge). When the battery is in operation it is also important to know the state of charge. Here, the main goal of the state of charge analysis for VRLA batteries is to provide means for calculating the available energy in a battery system which is in operation.

In the current state of the art there are the following methods known to measure and estimate the SOC for lead-acid battery systems:

- Coulomb counting method (CC).
- internal resistance measurement method (IRM);
- electrolyte specific gravity method (ESG);
- open-circuit voltage method (OCV);
- closed-circuit voltage method (CCV)

Each of these methods has its advantages and limitations and can't be directly used when the battery is in operational use for its application. In the following description of the proposal the term "battery assembly" will be used throughout the document. By the use of this term it is intended to reflect that there is no limitation in the number of batteries which are combined in an energy storage. This includes that only a single rechargeable battery is present in the battery assembly.

The Coulomb counting method is based on building the integral of the battery's current to estimate SOC [1]. If the current given from a battery assembly is measured accurately and there is enough data available about the initial state of charge of the battery assembly, then the Coulomb counting method is a simple and stable method. Unfortunately, there exist some problems with this method. In most cases the discharge current is not constant and is permanently changing during battery operation. Moreover, it only calculates changes in the state of charge. In order to define the current battery state it is therefore necessary to also know the initial state of charge and the actual battery capacity before starting discharging/charging cycles, the two of which besides other factors are subject of changing due to the aging process.

The internal resistance characterizes the capability of the battery to handle a certain load. Internal resistance is a parameter that can be used to roughly estimate a battery state since it varies with the state of charge of the battery [2]. Hereby changes in the active chemicals of the battery have a significant impact on its internal resistance. At the end of the battery discharge cycle, the internal resistance is rapidly increasing. This is bad for voltage sources which should have a very low internal resistance. Apart from its dependency of the state of charge, the internal resistance has certain relations with the battery life time, i.e. it becomes higher with the aging of the battery. This interrelation between the charging state and the aging of the battery makes it more difficult to exactly determine the state of charge by measuring the internal resistance.

The electrolyte specific gravity (ESG) method is another way to determine SOC of lead-acid batteries. As the battery is discharged, the active electrolyte, the sulphuric acid is consumed and the concentration of the sulphuric acid in water is reduced. This in turn reduces the specific gravity in direct proportion to the state of charge [3]. Thus, it is possible to define a current state of charge by measuring changes in the weight of the electrolyte. However, this technique of determining SOC is suitable for vented lead-acid batteries but is not applicable to VRLA batteries.

As another method for SOC estimation, also the open-circuit voltage method can be used. In the open-circuit voltage measurement technique the battery voltage is measured with a voltmeter while the battery is not powering a load. Although the OCV method is a simple and high-precision method, it is difficult to implement it as an in-operation monitoring strategy, because it requires a very long recover time for batteries in open-circuit, until a battery reaches a steady state which is suitable for measuring the final OCV after previous charging or discharging processes in lead-acid batteries. For operating this method, a battery has to be disconnected from the power system for a long time period for balancing the electrolytic reactions, before it can obtain a stable value of open-circuit voltage.

Alternatively to the OCV method, there exists the so-called closed-circuit voltage (CCV) method which also can be considered, since the SOC of a battery is approximately a linear function of the CCV. However, the closed-circuit voltage is very dependent from the discharge current, so it is quite difficult to make a right correspondence between CCV and SOC during battery operations.

From US 2013/0110428 A1 it is known a method and system for estimating a capacity of a battery. The method includes waiting until the open-circuit voltage of a battery rises to reach a certain change rate and performing a prediction process in form of an extrapolation from that point to obtain an estimated point where the corresponding open-circuit voltage may be regarded as in a stable state.

From US 2010/007309 A1 it is known a method for determining the state of charge of a battery in charging or discharging phase at constant current. It comprises placing the battery in open-circuit state during a recovery period until the voltage at the terminals of said battery stabilizes at a voltage plateau. Then a constant test voltage is applied to the battery terminals during a preset test period. The state of charge of the battery corresponds to the current measured at the end of the test period by means of a previously obtained calibration curve.

There is therefore a need for an improved approach for an SOC determination process which in particular is suitable for operational use in applications of the battery assembly. This corresponds to the problem of the invention.

This object is achieved by a method for estimating the state of charge SOC of a battery assembly according to claim 1, a corresponding apparatus for performing the method steps according to claim 11, and a corresponding computer program according to claim 14. The dependent claims include advantageous further developments and improvements of the invention as described below.

The solution is based on a measurement setup and some sophisticated machinelearning (ML) algorithms with which it is possible to provide means to measure and estimate energy reserves in battery systems under particular load and charging conditions. Such algorithms presume the availability of some switching and control in the power system and provide information about the actual state of charge, amount of available capacity (energy) and estimate available work time under given power consumption conditions.

The given research figured out means based on ML methods which improve the accuracy of SOC estimations against the state of the art significantly.

The proposal concerns an improvement in a method for estimating the state of charge of a battery assembly, comprising the steps of

- determining the correspondence between the dependency of the state of charge of a battery, to the open-circuit voltage of said battery,
- monitoring the slope of a voltage recovery curve in a resting period of said battery and checking if the slope of said voltage recovery curve is below a predefined limit value,
- estimating the state of charge of the battery by adding a fixed voltage value $\Delta U$ to the momentary open-circuit voltage $U_{t1}$ measured for said point in time $t1$ for which it was found that the slope of said voltage recovery curve is below said predefined limit value and by looking up, the corresponding state of charge. The proposal has the advantage that the time for determining the current state of charge of the battery assembly is subjectively reduced. There is no need any longer to wait for the complete recovery of the battery in open-circuit mode, after a discharge phase. When a certain recovery level has been reached, the final state of charge will be estimated since the remaining recovery phase is quite similar regardless of which discharge current rate has been applied during the discharge phase.

According to another embodiment the step of determining the correspondence between the dependency of the state of charge of the battery assembly to the open-circuit voltage of said battery assembly is repeated for a plurality of times. This correspondence needs to be determined in a training phase of said machine learning algorithm. After capturing the plurality of sets of measurement samples in said training phase a step of determining a best fit line is performed. This could in particular for VRLA batteries be done in the form of a linear regression line with a linear regression algorithm.

It is also advantageous to perform the step of determining the correspondence between the dependency of the state of charge of the battery assembly to the open-circuit voltage of said battery assembly in a resting mode, where the battery is neither put in a discharging mode nor in a charging mode. This way it is possible to determine the correspondence accurately enough.

In this regard it is also advantageous that in case that the resting mode is interrupted before the step of determining the state of charge to open-circuit voltage is finished, the step of determining the correspondence is repeated in a following resting mode. It is difficult to predict how long the respective resting mode will last, therefore one approach is to enter a trial and error process. An alternative solution is to predetermine certain time periods for the resting mode.

In one advantageous further embodiment two or more battery assemblies are provided and the method comprises a step in which it is switched between the battery assemblies, such that while one battery assembly is put in discharging mode or charging mode the one or more other battery assembly is put into the resting mode in which the steps of determining the correspondence, monitoring the slope of a voltage recovery curve and estimating the state of charge are performed.

For estimating the stable open-circuit voltage for the battery assembly it is advantageous to use the formula: $OCV = U_{t1} + \Delta U$, with $\Delta U = U_{t_{ocv}} - U_{t1}$, where

OCV corresponds to the estimated open-circuit voltage,

$U_{t_{ocv}}$ corresponds to the measured open-circuit voltage which is recorded for the measured $U_{t1}$ value as being the final open-circuit voltage for that normalized discharge current rate. This formula is easy to implement. The $U_{t1}$ value can be measured in a rather short time period up to approximately an hour. The $\Delta U$ value is known from the training phase and thus could be taken from a recorded table.

In a further enhanced embodiment it is advantageous for determining the correspondence between the dependency of the state of charge of the battery to the open-circuit voltage of said battery assembly to place the battery assembly in a discharging mode with a load that corresponds to a certain normalized discharge current rate, wherein a Coulomb counting method is applied to calculate the amount of charge $C_{rem}$ which is removed from the battery assembly and wherein the state of charge $SOC$ reached in said discharging mode is determined according to the formula

$$SOC = \left(1 - \frac{C_{rem}}{C_{tot}}\right) \cdot 100\%$$
, where

$C_{tot}$ corresponds to the total capacity of a fully charged battery assembly, that corresponds to the normalized discharge current rate with which the battery assembly is discharged. Also this formula is easy to implement and does not cause a higher calculation expenditure.

Here, it is also advantageous for the Coulomb counting method that the extracted charge $C_{rem}$ from the battery is calculated according to the formula

$$C_{rem} = I_d \cdot \Delta t,$$

where

$I_d$ - corresponds to the measured discharge current; and
$\Delta t$ - corresponds to the discharge time between two samples of measurements.

The Coulomb counting method primarily will be used in a training phase before going life with the battery assembly in its application. The discharge current and time intervals, will be measured incrementally, and we can experimentally find the removed charge $C_{rem} = I_d \cdot \Delta t$ and the corresponding SOC value at any time as

$$SOC = \left(1 - \frac{C_{rem}}{C_{tot}}\right) \cdot 100\%$$
. This way the correspondence of SOC to OCV value can be found. Further this correspondence will be used in the opposite direction, too: to find the SOC state from OCV value. Here, $\Delta t$ should be kept reasonably small as the current changes permanently. The recommended $\Delta t$ interval is 1-60 sec depending on the type of load (when discharge current is more or less constant the interval can be rather long, on high frequency changes it shall be significantly reduced).

The Coulomb counting method can also be used in an SOC determination algorithm for the life and operational use of the battery assembly along with the OCV method for rough estimations of SOC changes, specifically in moments when OCV method cannot be used as the battery is in charging/or discharging mode.

To keep the applicability of the above described solution, it is very advantageous to periodically put the battery assembly into a maintenance mode in which the step of determining the correspondence between the dependency of the state of charge of the battery assembly to the open-circuit voltage of said battery assembly is repeated.

The invention also concerns a correspondingly adapted apparatus for estimating the state of charge SOC of a battery assembly.

For such an apparatus it is advantageous that the apparatus comprises at least one battery assembly, one load resistor and at least one voltmeter and an ammeter, further comprising one or more controllable switching elements and a microcontroller, said microcontroller being adapted to perform data logging for the measurement samples of the battery voltages and the discharge currents, to count said time values and to control the one or more switching elements to switch the battery assembly in either the discharging mode respectively charging mode or resting mode, and to perform the calculations according to the steps of the method. The voltmeters and ammeter should be equipped with digital interface such that the microcontroller can read in the current measurement sample values. This corresponds to the apparatus that might be used in the operational use SOC determination phase when the battery assembly is put in life working conditions.

It is an enhanced embodiment of this that the apparatus comprises two battery assemblies, wherein the microcontroller is adapted to control the one or more switching elements in such a manner, that one battery assembly is put into a resting mode while the other battery assembly is put into charging or discharging mode. This way the problem that due to a high duty cycle of the battery assembly it is not possible to put it in resting mode long enough to determine the current state of charge can be solved. This is particularly an advantage for energy autarkic applications where there is a problem to switch off the battery assembly from the load, e.g. if a compartment needs to be cooled down, because it contains perishable goods.

The proposed solution works very well for a battery assembly which comprises a string of valve regulated lead-acid batteries VRLA or a string of vented lead acid batteries.

The invention also concerns a corresponding adapted computer program with instructions which perform the method for estimating the state of charge SOC of a battery assembly.

In the following, the invention will be described by means of advantageous embodiments with reference to figures of a number of drawings. Herein:

Fig. 1    shows an empirically measured open-circuit recovery process for an 48 V lead-acid battery assembly;

Fig. 2    shows the voltage recovery process after two different discharge processes at two different states of charge;

Fig. 3    shows a plurality of voltage recovery processes after discharging processes with different discharge current rates (CR) for an 48V battery system;

Fig. 4    shows the change of voltage recovery speed during the resting period in an exemplary voltage recovery process;

Fig. 5    shows the electrical scheme of an experimental measurement setup;

Fig. 6    shows the dependency of the battery capacity on the discharge time for a VRLA battery with the capacity $C_{100h}$ = 472 Ah;

Fig. 7    shows the dependency of the battery capacity on the discharge current for the same type of VRLA battery;

Fig. 8    shows the dependency of the open-circuit voltage vs state of charge for the same type of 48 V battery assembly at different C-rates;

Fig. 9    shows the electrical scheme of a battery installation for a first proposed technique of measuring the OCV vs. SOC dependency in life scenarios where the battery assembly is put in operation for energy supply in an application; and

Fig. 10   shows the flow chart for a computer program for implementing an algorithm for measuring the OCV vs. SOC dependency in operational applications of the battery assembly according to a second proposed technique.

The present description illustrates the principles of the present disclosure. It will thus be appreciated that those skilled in the art will be able to devise various arrangements that, although not explicitly described or shown herein, embody the principles of the disclosure.

All examples and conditional language recited herein are intended for educational purposes to aid the reader in understanding the principles of the disclosure and the concepts contributed by the inventor to furthering the art, and are to be construed as being without limitation to such specifically recited examples and conditions.

Moreover, all statements herein reciting principles, aspects, and embodiments of the disclosure, as well as specific examples thereof, are intended to encompass both structural and functional equivalents thereof. Additionally, it is intended that such equivalents include both currently known equivalents as well as equivalents developed in the future, i.e., any elements developed that perform the same function, regardless of structure.

Thus, for example, it will be appreciated by those skilled in the art that the diagrams presented herein represent conceptual views of illustrative circuitry embodying the principles of the disclosure.

The functions of the various elements shown in the figures may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, read only memory (ROM) for storing software, random access memory (RAM), and nonvolatile storage.

Other hardware, conventional and/or custom, may also be included. Similarly, any switches shown in the figures are conceptual only. Their function may be carried out through the operation of program logic, through dedicated logic, through the interaction of program control and dedicated logic, or even manually, the particular technique being selectable by the implementer as more specifically understood from the context.

In the claims hereof, any element expressed as a means for performing a specified function is intended to encompass any way of performing that function including, for example, a) a combination of circuit elements that performs that function or b) software in any form, including, therefore, firmware, microcode or the like, combined with appropriate circuitry for executing that software to perform the function. The disclosure as defined by such claims resides in the fact that the functionalities provided by the various recited means are combined and brought together in the manner which the claims call for.

A preferable implementation of the proposed methods can be shown in a number of experiments which are carried out in order to investigate the behavior of VRLA and vented lead-acid batteries. For these experiments, a specific battery system has been assembled. The experimental setup for showing the effects of a preferred embodiment consists of 24 lead-acid batteries, each of which is a 2V battery, which are connected in series to get a single 48V battery assembly. To measure the open-circuit voltage simply an accurate voltmeter is required.

It is hardly possible to implement an open-circuit voltage method as a real-time monitoring strategy, because voltage requires a long time period (mostly several hours) to recover and become stable and suitable for measuring after charging or discharging processes of lead-acid batteries. However, the aim of this invention is to provide means to find dependencies and patterns that will be used to accelerate the process of determining the value of open-circuit voltage, which would prevail after complete recovery in order to determine the corresponding SOC of the battery.

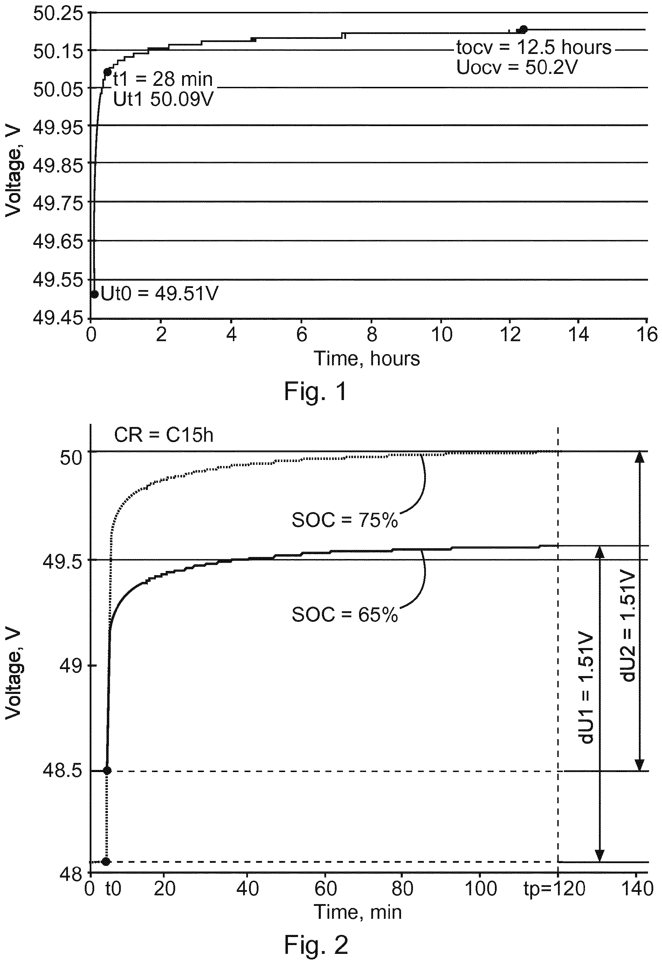

Empiric analyses of the OCV recovery over the time show that the process of recovery lasts more than 12 hours, as can be seen in Fig. 1. The open-circuit voltage remains stable with a measurement accuracy of 0.01 V for an increasing time interval when observing the curve from left to right in Fig. 1.

In general, when describing battery properties, the discharge current is often expressed as a C-rate (CR) in order to normalize a particular discharge current against the battery capacity. A $C_{100h}$ rate means that the discharge current will discharge the entire battery in 100 hours. For a battery assembly with a capacity $C_{100h}$ = 472 Ah this equates to a normalized discharge current of 4.72 A.

For the analysis of the dependency of the OCV recovery process from the actual state of charge, the battery was discharged by a constant current (at discharge current rate CR=$C_{15h}$). At different states of charge the discharge process was stopped in order to get a graph for the voltage recovery process.

Fig. 2 shows the voltage recovery process for the same type of VRLA battery starting at two different current states of charge. On the Fig. 2 one measured recovery process curve starts at a terminal voltage of 48.1 V and the other at 48.5 V. Here, the terminal voltage 48.1 V corresponds to a state of charge of 65% and 48.5 V correspond to an SOC of 75%. In Fig. 2:

$t_0$ - corresponds to the instant at which the load was disconnected and the process of voltage recovery starts;

$t_p$ - corresponds to the period of time at which the comparison of different recovery processes is done;

*dU1, dU2* - correspond to the change in voltage during recovery process for the time period of *tp*.

During the predefined time $t_p$ = 120 min after the load was disconnected from the battery at different stages of charge (SOC 65%, SOC 75%), the recovery process proceeded the same way so the voltage was recovered by the same value, i.e. *dU1 = dU2*. The analysis of the results, as shown in Fig. 2, reveals that the recovery process does not depend (for the same discharge current rate) on the SOC level where the recovery process was initiated.

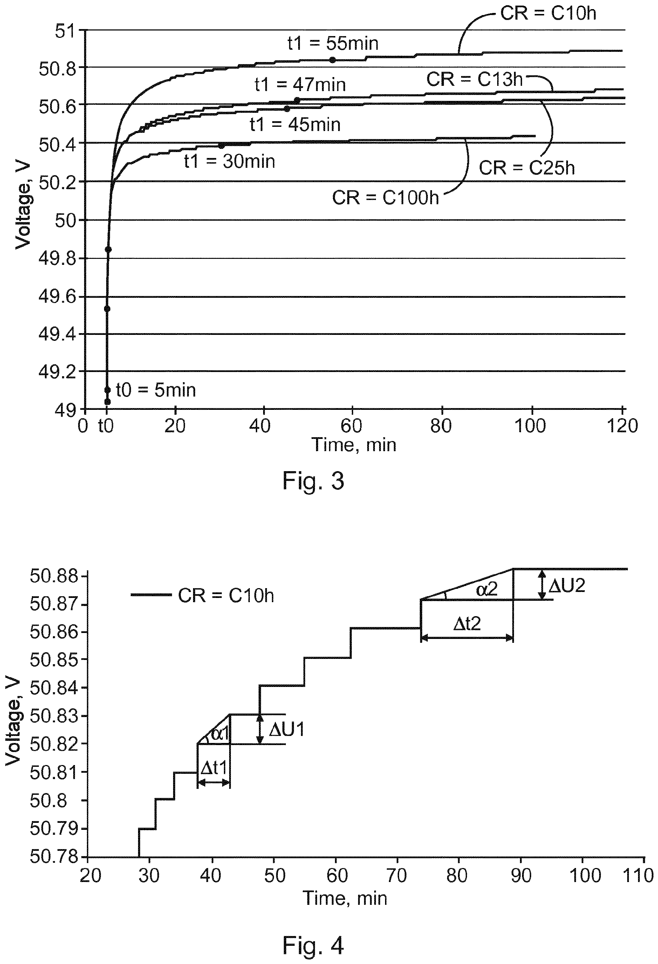

Fig. 3 now shows the dependency of the voltage recovery process on different discharge current rates (CR) for the same type of 48 V battery system. The voltage recovery processes after different discharge current rates are shown on the Fig. 3.

The analysis of the curves shows that the value of discharge current influences the recovery characteristics. The speed of recovery at the beginning of the recovery process is different for different values of discharge current.

However, after some moment ($t_1$) the process of recovery proceeds in the same way and regardless of the former discharge current. For the CR=C10h curve *t1* corresponds to *t1=55 min.* For the CR=C13h curve *t1* corresponds to *t1=47 min.* For the CR=C25h curve *t1* corresponds to *t1=45 min.* For the CR=C100h curve *t1* corresponds to *t1=30 min.* All these curves reveal, the general behavior that the recovery speed decreases when the discharge current during the discharge phase is getting higher.

The speed of the voltage recovery process can be characterized by the slope of the corresponding recovery curve. Fig. 4 shows a way how to determine the slope of the CR=C10h curve in different sections of the curve. The slope value can be determined by defining different steps of a stairway that is put underneath the curve to approximate the curve and calculating the tangent *tg(α),* of each step.

$$tg(\alpha) = \vartheta_{rec} = \frac{\Delta U, V}{\Delta t, min} \tag{1}$$

Where,

> $\vartheta_{rec}$ - corresponds to the speed of the voltage recovery;
> $\Delta U$ - corresponds to the minimal voltage change that can be measured (corresponds to the accuracy of the voltmeter and equals in the described experiment to 0.01 V);
> $\Delta t$ - corresponds to the time interval in which no change in voltage value is measurable.

On the Fig. 3, the points t1 correspond to the time in the recovery process, when the speed of voltage recovery

$$\vartheta_{rec} = 0.002 \; {}^{V}\!/_{min}$$

starts to be less than . Note, that this point may be determined by measuring the voltage change of 0.01 V and measuring the time how long it takes to measure a change in voltage of 0.01 V. If this time equals 5 min, the point is found.

This way it was found that it takes a different amount of time to reach the point t1 dependent on the previous C-rate. However, beginning from the point t1 the voltage starts to change approximately with the same speed and it does no more depend on what value of current the battery was discharged.

Taking this finding into consideration, it is one idea of the proposal to predict the value of OCV, starting from the moment t1 and thereby reducing subjectively the amount of time for finding the final value of OCV. During the time $\Delta T = t_{ocv} - t_1$, see Fig. 1, the voltage was changed by the value $\Delta U = U_{t_{ocv}} - U_{t_1}$. It means that OCV can be predicted as

$$OCV = U_{t1} + \Delta U. \tag{2}$$

In the range of discharge currents from C100h to C10h the required waiting time t1 to predict the value of OCV depends on the discharge current and lies in the range from 30 to 55 minutes for the particular 48 V battery assembly, see Fig. 3.

This proposal therefore has the advantage that the value of OCV can be determined in a relatively fast way (several minutes instead of up to 15 hours). The proposed methodology offers the opportunity to improve the OCV method subjectively and make it suitable for in-operation applications of the battery assembly.

Each battery assembly which is formed by a serial or parallel interconnection of several batteries will have a unique SOC vs OCV dependency due to the presence of variations in the parameters of each individual battery. For this reason, the individual SOC vs OCV dependency must be found empirically before the battery assembly will be used in the energy system. Corresponding proposals for reaching this are introduced bellow.

To find this individual SOC vs. OCV dependency for the VRLA and vented lead-acid battery assemblies, a machine learning algorithm is proposed hereinafter.

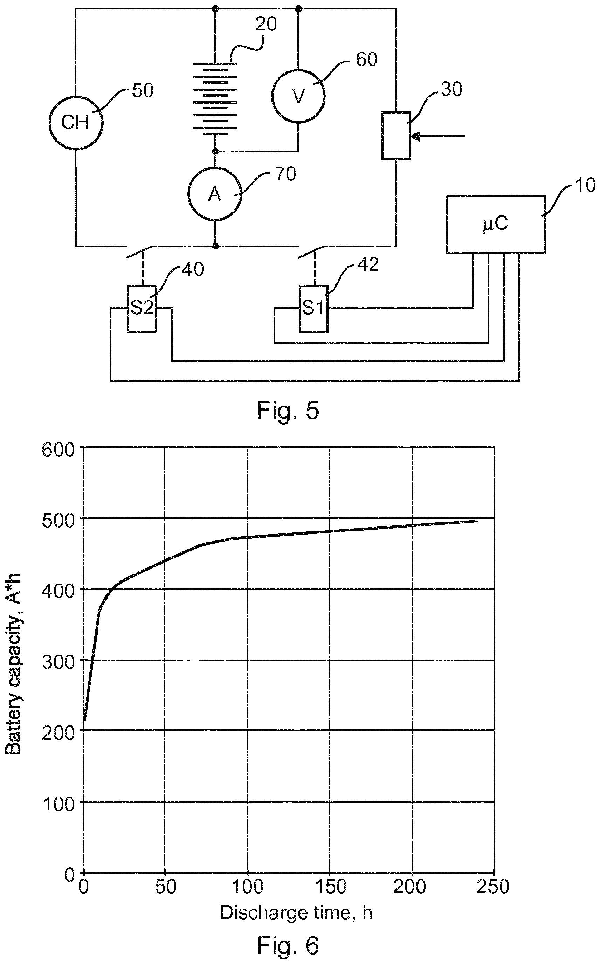

First, Fig. 5 shows the proposed structural scheme of the experimental measurement setup for performing certain tests with the 48 V battery assembly.

In Fig. 5 reference number 50 denotes the charging circuit, that provides the charging current for the battery assembly 20 after a discharge phase. On an energy autarkic application the battery will be charged by means of regenerative energy, such as solar energy, bio energy, wind energy, or the like. With reference numbers 40 and 42 two switching elements exemplified as relays are denoted which are controlled by a microcontroller 10 to select the mode of battery operation (charging, discharging). Reference number 30 marks a load through which the load current flows during the discharge phase. For making experiments a load cabinet with a regulated resistance with a good tolerance, e.g. less than 5% is used that gives the opportunity to discharge the battery assembly 20 with different values of discharge current. Reference number 60 denotes the voltmeter for checking the battery voltage during charging and discharge phase. With reference number 70 an ammeter is labelled with which the discharge current and charging current can be measured.

The total capacity of the battery assembly 20 depends on the discharge current rate actually used. An example of the dependencies of a battery capacity from discharge time and discharge current rate CR is shown in the table below, according to the datasheet of a particular real battery [4].

| CR | $C_{1h}$ | $C_{10h}$ | $C_{20h}$ | $C_{72h}$ | $C_{100h}$ | $C_{120h}$ | $C_{240h}$ |
|---|---|---|---|---|---|---|---|
| Battery capacity | 215 Ah | 364 Ah | 404 Ah | 460 Ah | 472 Ah | 477 Ah | 496 Ah |

Now, with such a setup, the individual SOC vs. OCV dependency can be determined with the following procedure:

1) A fully charged battery assembly 20 should be connected to the load cabinet 30 on which a defined load scenario can be selected. This way, the discharge will be done by the currents in the range from $C_{100h}$ to $C_{10h}$. Thus, it is necessary to set the appropriate value of the resistance of the load cabinet 30. A corresponding table may be recorded in the microcontroller 10 in which the setting of the load resistance for the different C-rates are listed.

2) The discharge phase is initiated by switching the switching elements 40, 42 accordingly. In the discharge phase relay 42 is closed and relay 40 is opened.

3) During the discharge phase the Coloumb counting method will be applied to calculate the amount of charge ($C_{rem}$) which is removed (extracted) from the battery. For this purpose the ammeter 70 is used. The extracted charge can be calculated according to the following formula:

$$C_{rem} = I_d \cdot \Delta t \tag{3}$$

where,

$I_d$ - corresponds to the discharge current;

$\Delta t$ - corresponds to the discharge time between two samples of measurements.

The time $\Delta t$ between two measurement samples of the current will also be counted and must be kept reasonably small such that in this period the current changes are insignificant. This way, the amount of charge measured in Ah which was extracted from the battery can precisely be calculated. This calculation corresponds to an integration of $C_{rem}$ values during the different measurement intervals. The typical duration for the measurement intervals lies in the range from 1 to 60 seconds and is recommended. The measurement values from ammeter and voltmeter will be automatically captured by the microcontroller 10, which therefore is connected with these instruments through a corresponding digital interface, not shown. The microcontroller 10 also performs further calculations of other parameters.

4) During the discharge phase, an algorithm running in the microcontroller 10 calculates the current value of SOC using the following formula:

$$SOC = \left(1 - \frac{C_{rem}}{C_{tot}}\right) \cdot 100\% \tag{4}$$

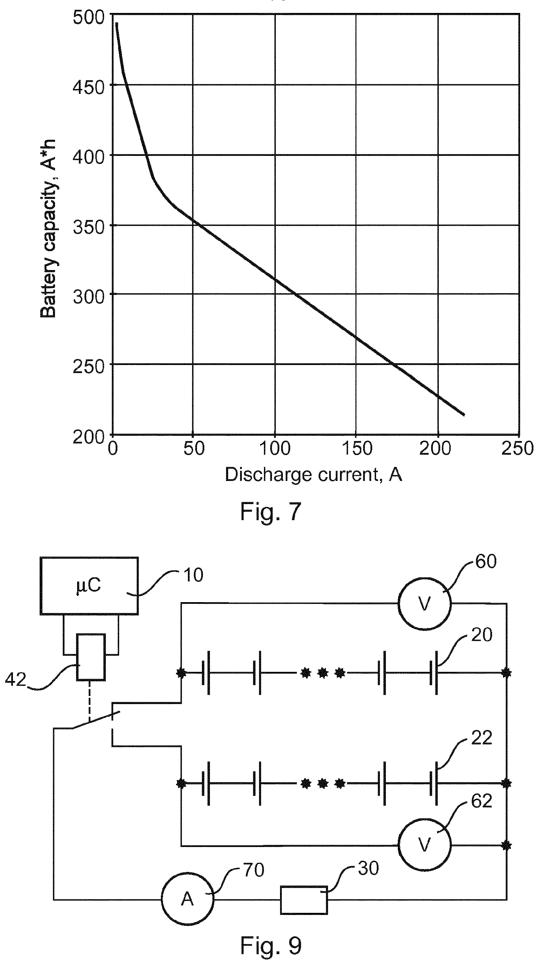

where, $C_{tot}$ corresponds to the total capacity of a fully charged battery, that is chosen according to the Fig. 7 in accordance with the appropriate discharge current.

5) Every time when the SOC is decreased by 5%, the discharge process should be paused by opening the switching elements 40 and 42 to measure the OCV. For this purpose also the voltmeter 60 will be used. After the OCV is measured, the discharge process will be continued.

6) In the 6th process step, the discharge process will be continued until a maximum acceptable level for the depth of discharge for a particular battery assembly is reached. The selection of the minimum value of SOC has an impact on the battery life since there exists the ruling that as deeper the battery is discharged, the less charging/discharging cycles may be performed causing the same aging effect. Moreover, the deep discharge of lead-acid batteries can lead to damaging of the internal structure of the battery. Considering these facts it is recommended to set the minimal acceptable value of SOC to be not less than 20%. This is equivalent to the statement that the so-called depth of discharge (DOD) should not be higher than 80%.

After the discharge process has been completed up to this level, the battery assembly 20 will be fully charged again, with relay 40 being closed and relay 42 opened.

The steps 1 to 6 of the SOC vs. OCV determination process could be performed manually but it is preferred to execute it in an automated way by using a correspondingly programmed microcontroller 10 along with digital ammeter 70 and digital voltmeter 60, and the microcontroller-controlled switching elements 40 and 42.

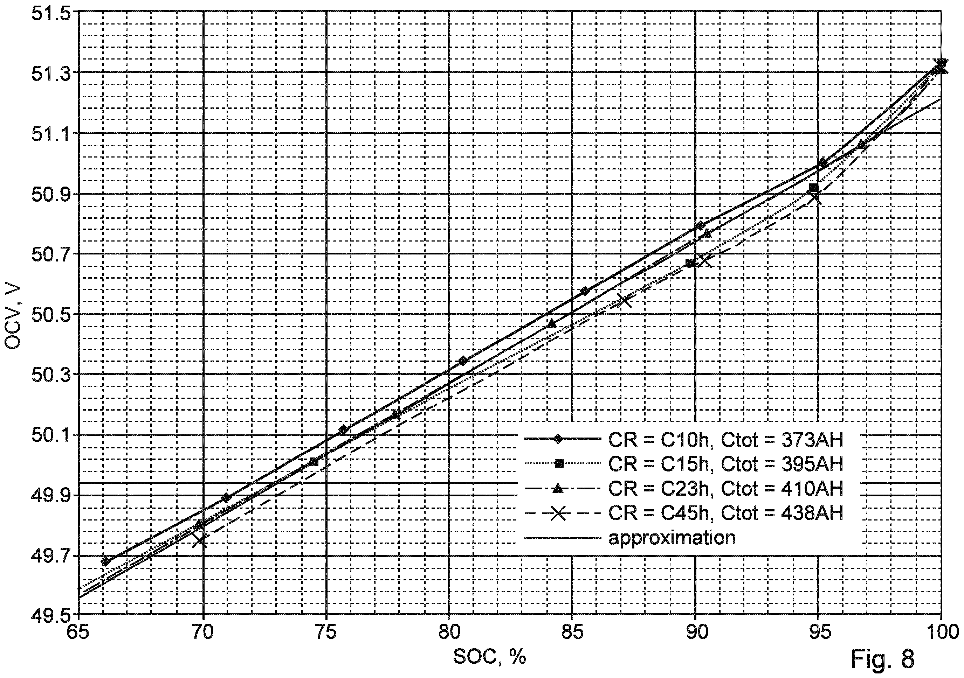

In order to find the right and precise correspondence between SOC and OCV the measurements in said SOC vs. OCV determination process should be repeated several times for different normalized discharge currents. The final OCV value can be estimated based on formula (2) using the approach described above to accelerate the process of finding OCV vs SOC correspondence. Fig. 8 shows the array of curves, compiled by applying said process described above multiple times for different C-rates.

7) Since the curves up to an SOC of 92% follow a straight line and lie close together it is a further proposal to approximate them by a straight line in a further step 7 to simplify the SOC calculation in in-operation applications of the battery assembly. In one embodiment this could easily be done with a linear regression calculation (linear regression line calculation). The bold black line in Fig. 8 shows the resulting regression line after such an approximation. In this example the deviation from the approximated regression line does not exceed 2% of the measured SOC value. This step can also be performed by implemented a corresponding regression algorithm in the microcontroller 10 or another microcomputer.

At this stage of investigations the following conclusions can be drawn.

Statement 1:

The OCV method is fairly stable and presents approximately a linear function of the value OCV in dependence of the SOC state. This holds for at least the SOC range 60 - 100% where the investigations have been performed. To simplify the SOC calculation, it is recommended to approximate the array of curves for different discharge currents by a linear regression function to make this method to be suitable and convenient for in-operation applications of the battery assembly.

Statement 2:

The OCV determination method has a monotonic dependency from the value of discharge current. It means that: the more range of discharge currents is available in the system, the higher the deviation appears between the curves on the OCV vs. SOC graph depicted in Fig. 8. For this reason the OCV determination process proposed above requires an operation of the energy system in some strictly limited discharge current boundaries.

During the lifetime of a battery, its performance or "health" tends to deteriorate gradually due to irreversible physical and chemical changes which take place with usage and with aging of the battery until eventually the battery is no longer usable [5]. To monitor the battery during its lifetime, an important term when considering the aging process of a battery is its state of health (SOH).

The state of health is a concept that reflects the general condition of a battery and its ability to deliver the specified performance compared with a fresh battery. It takes into account such factors as charge acceptance, internal resistance, voltage and selfdischarge. It is a measure of the long term capability of the battery. The SOH value is defined to express how weak the battery is and represents the percentage of remaining capacity to the initial capacity when the battery is brand new.

Given the above it is obvious that in the long run the characteristic curves of OCV vs. SOC dependency as seen in Fig. 8 will be biased against their initial condition. This will lead to an increase in the error in SOC determining. For this reason it's recommended to put the battery assemblies periodically (e.g. every 4-6 months) into a specific mode which will be called the "maintenance mode" hereinafter.

The term "maintenance mode" implies a necessity to repeat the calibration of the SOC vs. OCV dependency in accordance with the process presented above. After each execution of the maintenance mode a new array of curves for different normalized discharge currents is measured and thus a new regression line is calculated.

As the investigation explained above show, the battery voltage requires more than 10 hours of recovery time to reach the final OCV value after a discharging process of lead-acid battery was performed. This is not acceptable for in-operation applications of the battery assembly.

For this reason a new method is proposed that allows to find the OCV value significantly faster. In contrary to the state of art approach, the proposed method above requires a waiting time *t1* to predict the value of OCV of only up to 55 minutes as depicted in Fig. 3. Moreover, as it was also shown above, the OCV vs. SOC dependency corresponds to a linear function, see Fig. 8 so the SOC state could be easily calculated when the OCV value is known.

Here, two different approaches are proposed for finding the value of SOC in in-operation applications of the battery assembly.

The first approach implies the availability of an additional set of batteries and includes 2 techniques.

According to the first embodiment two assemblies of batteries have the same main technical parameters ($U_{string1}$ = $U_{string2}$, $C_{string1}$=$C_{string2}$) and operate alternately. The structural scheme of the setup is presented in Fig. 9. The same reference numbers denote the same components as shown in Fig. 5. While the first battery assembly 20 operates and supplies the equipment, the second assembly of batteries 22 has a rest time that makes it possible to find its OCV value as well as the SOC state using the methods described above. Also during this time the second battery assembly 22 can be put into the above mentioned maintenance mode if necessary. The maintenance mode implies the calibration of the SOC vs. OCV dependency. For this, several charge/discharge cycles must be provided as described in the above explained procedure (steps 1 - 7). The duration of this procedure depends on various conditions (capacity of the battery assembly, performance values of the charging circuit and so on).

When the OCV value and SOC state is determined for the second assembly of batteries 22 the relay 42 will be switched by a control signal of microcontroller 10 thereby changing the active battery assembly. It is noted that there are two voltmeters 60 and 62 for measuring voltages of the two battery assemblies 20, 22 separately.

According to the second embodiment, the main assembly of batteries 20 is supplemented with an additional battery assembly 22 with the same voltage level, however with a significantly lower capacity. The second battery assembly 22 works in this case as a buffer and is used only to provide a rest time (up to 60 minutes) for the first battery assembly 20 to find OCV and SOC values for the first battery assembly 20. In this embodiment the equipment is supplied with the first battery assembly 20 until the moment when it is time for a new measurement of the SOC state. The microcontroller 10 in one embodiment is programmed to start the SOC state measurement phase regularly in a predetermined time interval, e.g. once in week. The structural scheme of the setup for the second embodiment is like the one presented on Fig. 9, however the capacities of the battery assemblies 20, 22 differ subjectively ($U_{string1}$ = $U_{string2}$, $C_{string1}$ >> Cstring2).

The second approach doesn't require additional batteries or additional equipment. The setup for this approach is like in Fig. 5. The idea of this approach is based on an algorithm that makes use of the combination of the 2 methods (OCV determination and Coulomb counting as described above) to calculate SOC state during the duty cycle of the batteries. This approach is called "opportunistic approach".

The charge in a battery is equal to the current multiplied by the time for which it flowed. The Coulomb counting method itself is not able to provide the information about SOC, however it can calculate the changes in state of charge during operation by measuring the battery current. Depending on the current flow throw the battery, the algorithm can distinguish 3 modes of battery operation: *resting mode, charging mode* and *discharging mode.*

The "*Discharging mode*" corresponds to the case when the current flows out of the battery ($I_{bat} < -C_{100h}$). The amount of charge which is removed from the battery assembly 20 during a short period of discharge as well as the current value of SOC will be calculated by microcontroller 10 using formulas (3) and (4).

The *"Charging mode"* corresponds to the case when the current flows into the battery ($I_{bat} > C_{100h}$).

In time periods when the value of the battery current $I_{bat}$ lies in the range from $-C_{100h}$ to $C_{100h}$ the algorithm will enter to the *"resting mode"* and will try to find the OCV value. If *"resting mode"* lasts long enough to find OCV, the algorithm will calculate the precise value of SOC using said OCV method that was described above. If, however during operations energy is needed by consumers and the instant current raises to a value higher than $C_{100h}$ the process of OCV determination will be interrupted and the system waits for the next opportunity to enter the "resting mode". This is why this algorithm is called "opportunistic approach". It is important to understand that dependent on the energy usage profile in the system it can happen that there will never be found a long enough gap in energy consumption of the system such that the OCV value and therefore the SOC state could be determined. So, while some energy systems can rely on the "opportunistic approach" other systems can use the opportunistic mode in conjunction with the proposal of using two battery assemblies in order to reduce the maintenance overhead. Also it has to be noted that the re-calibrations of the OCV/SOC lines in the "opportunistic approach" can have a quite low success probability since it needs a time from several hours to several days of being disconnected from the load. So, in setups with a pure opportunistic approach the re-calibration of OCV/SOC dependency possibly has to be initiated and performed manually.

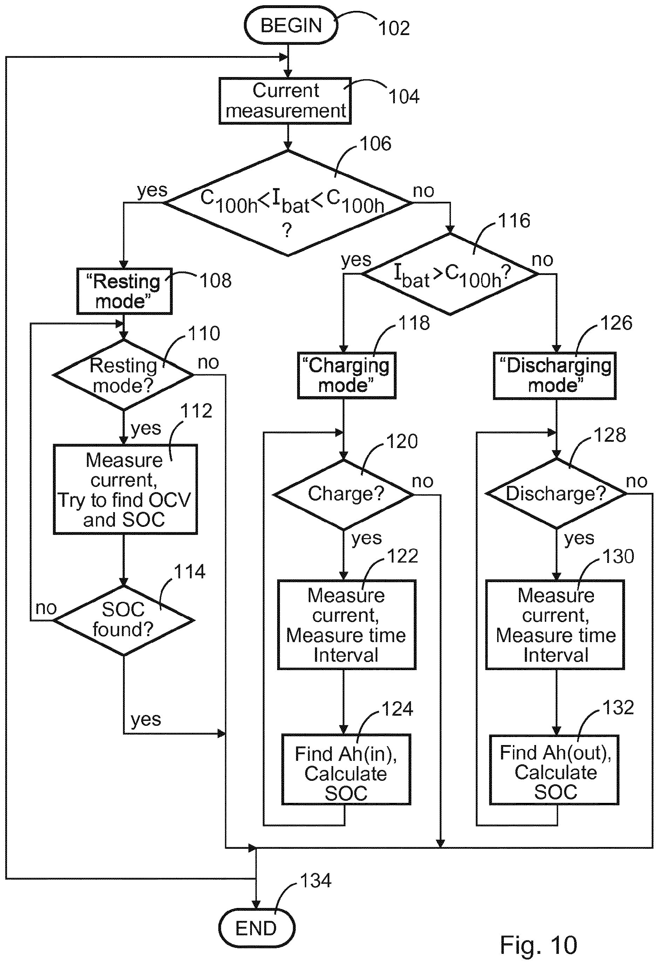

Fig. 10 now shows a flow chart for a computer program that runs in microcontroller 10 for implementing the proposal. Note that the setup depicted in Fig. 5 may be applied when running this program. A similar program may be applied when the setup according to Fig. 9 is used. Reference number 102 marks the start of the program. In program step with reference number 104 the active discharging current that is measured with ammeter 70 is read out. In query 106 it is checked if the active discharging current value lies in the range $-C_{100h} < I_{Bat} < C_{100h}$. If yes, the program decides that the battery assembly is in resting mode and branches to the program step 108. In program step 108 it is checked if the resting mode is stable. Here, it will be checked if the discharging current is stable. If it varies, it might be that the resting mode is not active. At the end of this step it will be defined that the resting mode was entered or not.

In query 110 it will be checked what was defined in the previous step. If it was found that the resting mode has not been entered, the program branches to the end of the program in step 134. If the resting mode was entered, the program continues with step 112. In step 112 the program tries to find the stable open-circuit voltage. This may take up to 30 min, see in Fig. 3 the curve with CR = $C_{100h}$ or up to 55 min for the curve CR = $C_{10h}$. So what happens are periodic (cyclic) measurements of the current and voltage with a measurement interval of e.g. 1-60 sec. After each measurement cycle the program checks in query 114 whether the SOC was found. If not, the program loops back to query 110 where it will be checked, whether the battery is still in resting mode (depending on the measured current). If the OCV value at the time t1 could be measured, the final OCV value will be estimated with formula 2 and thus the SOC state will be determined based on the regression line recorded in memory as explained above. This OCV value will be registered in memory at query 114 and the program ends in step 134. An application program can make use of the current state of charge registered in memory and continue discharging the battery assembly 20 or start charging the battery assembly 20.

When in the next run of the program it will be found in query 106 that $I_{Bat}$ is outside the checked range, the program continues with step 116. Here, it will be checked if the measured $I_{Bat}$ value is greater than $C_{100h}$. If yes, the requirements for a stable charging mode will be checked in step 118. If yes, it will be defined that the charging mode is active. The following query 120 checks if an active charging mode was registered in the step 118. If not, the program ends in step 134. If yes, the charging current will be measured in intervals, e.g. 1 min intervals in step 122. In step 124 the Coulomb counting method is applied to calculate the amount of charge $C_{rem}$ which flows into the battery assembly and wherein the state of charge *SOC* reached in said charging mode is determined according to the formula (4). After this, the program loops back to query 120 and monitors the next interval in charging mode.

If in query 116 it was found that current flows out of the battery assembly 20, the requirements for a stable discharging mode will be checked in step 126. If yes, it will be defined that the discharging mode is active. The following query 128 checks if an active discharging mode was registered in the step 126. If not, the program ends in step 134. If yes, the discharging current will be measured in intervals, e.g. 1 min intervals in step 130. In step 130 the Coulomb counting method is applied to calculate the amount of charge $C_{rem}$ which is removed from the battery assembly 20 and wherein the state of charge *SOC* reached in said discharging mode is determined. After this the program loops back to query 128 and monitors the next interval in discharging mode.

It is to be understood that the proposed method and apparatus may be implemented in various forms of hardware, software, firmware, special purpose processors, or a combination thereof. Special purpose processors may include application specific integrated circuits (ASICs), reduced instruction set computers (RISCs) and/or field programmable gate arrays (FPGAs). Preferably, the proposed method and apparatus is implemented as a combination of hardware and software. Moreover, the software is preferably implemented as an application program tangibly embodied on a program storage device. The application program may be uploaded to, and executed by, a machine comprising any suitable architecture. Preferably, the machine is implemented on a computer platform having hardware such as one or more central processing units (CPU), a random access memory (RAM), and input/output (I/O) interface(s). The computer platform also includes an operating system and microinstruction code. The various processes and functions described herein may either be part of the microinstruction code or part of the application program (or a combination thereof), which is executed via the operating system. In addition, various other peripheral devices may be connected to the computer platform such as an additional data storage device and a printing device.

It should be understood that the elements shown in the figures may be implemented in various forms of hardware, software or combinations thereof. Preferably, these elements are implemented in a combination of hardware and software on one or more appropriately programmed general-purpose devices, which may include a processor, memory and input/output interfaces. Herein, the phrase "coupled" is defined to mean directly connected to or indirectly connected with through one or more intermediate components. Such intermediate components may include both hardware and software based components.

It is to be further understood that, because some of the constituent system components and method steps depicted in the accompanying figures are preferably implemented in software, the actual connections between the system components (or the process steps) may differ depending upon the manner in which the proposed method and apparatus is programmed. Given the teachings herein, one of ordinary skill in the related art will be able to contemplate these and similar implementations or configurations of the proposed method and apparatus.

**Reference Sign List**

| 10 | Microcontroller |
| 20 | 1st Battery Assembly |
| 22 | 2nd Battery Assembly |
| 30 | Load Resistance |
| 40 | 1st Switching Element |
| 42 | 2nd Switching Element |
| 50 | Charging Electronics |
| 60 | 1st Voltmeter |
| 62 | 2nd Voltmeter |
| 70 | Ammeter |
| 102 - 134 | Different Program Steps of a Computer Program |

**Reference List**

[1] Haiying Wang, Yang Liu, Hang Fu, Gechen Li, "Estimation of State of Charge of Batteries for Electric Vehicles", International Journal of Control and Automation Vol. 6, No. 2, April, 2013, p.187

[2] Industrial batteries, VRLA Handbook.URL: http://www.produktinfo.conrad.com/datenblaetter/250000-274999/255564-da-01-en-Panasonic Bleiakku LCR 12V17CP.pdf

[3] Barrie Lawson, "State of Charge (SOC) Determination", 2005.URL: http://www.mpoweruk.com/soc.htm

[4] Technical Specification for Valve Regulated Lead-Acid Batteries (VRLA-GEL), September 2013.URL:http://www.moll-batterien.de/dateien/pdfs/MOLL TechSpez OPzV solar en.pdf

[5] Barrie Lawson, "State of Health (SOH) Determination", 2005.URL: http://www.mpoweruk.com/soh.htm

**Claims**

1. Method for estimating the state of charge of a battery assembly (20, 22), comprising the steps of

   - determining the correspondence between the dependency of the state of charge of a battery assembly (20, 22) to the open-circuit voltage of said battery assembly (20, 22) in a training phase for a plurality of different discharge currents,

   - performing a step of determining a best fit line with the plurality of data sets captured during the training phase,

   - monitoring the slope of a voltage recovery curve in a resting period of said battery assembly (20, 22), where the battery assembly is neither put in a discharging mode nor in a charging mode and checking if the slope of said voltage recovery curve is below a predefined limit value,
   - estimating the state of charge of the battery assembly (20, 22) by adding a fixed voltage value $\Delta U$ to the momentary open-circuit voltage $U_{t1}$ measured for said point in time $t1$ for which it was found that the slope of said voltage recovery curve is below said predefined limit value; wherein the fixed voltage value $\Delta U$ is taken from the training phase, to get the stable open-circuit voltage $U_{t1}$ and by looking up, the corresponding state of charge in said best fit line with the resulting stable open-circuit voltage.

2. Method according to claim 1, wherein the step of determining the correspondence between the dependency of the state of charge of a battery assembly (20, 22), to the open-circuit voltage of said battery assembly (20, 22) is repeated for a plurality of times in said training phase and wherein for the plurality of sets of measurement samples a best fit line is determined, in the form of a linear regression line.

3. Method according to claim 1 or 2, wherein the step of determining the correspondence is performed in a resting mode, where the battery assembly (20, 22) is neither put in a discharging mode nor in a charging mode.

4. Method according to claim 3, wherein in case that the resting mode is interrupted before the step of determining the correspondence between the dependency of the state of charge to open-circuit voltage is finished, the step of determining the correspondence is repeated in a following resting mode.

5. Method according to claim 3, wherein two or more battery assemblies (20, 22) are provided and wherein it is switched between the battery assemblies (20, 22), such that while one battery assembly (20, 22) is put in discharging mode or charging mode the one or more other battery assembly (20, 22) is put into said resting mode in which the steps of determining the correspondence, monitoring the slope of a voltage recovery curve and estimating the state of charge are performed.

6. Method according to any one of the previous claims, wherein the stable open-circuit voltage for the battery assembly (20, 22) is estimated according to the formula

$$OCV = U_{t1} + \Delta U, \text{ with } \Delta U = U_{t_{ocv}} - U_{t_1},$$

where

OCV is the estimated stable open-circuit voltage,
$U_{t_{ocv}}$ is the open-circuit voltage which is recorded for the measured $U_{t1}$ value as being the final open-circuit voltage for that normalized discharge current rate.

7. Method according to any one of the previous claims, wherein for determining the correspondence between the dependency of the state of charge of the battery assembly (20, 22), to the open-circuit voltage of said battery assembly (20, 22) said battery assembly (20, 22) is put in a discharging mode with a load that corresponds to a certain normalized discharge current rate, wherein a Coulomb counting method is applied to calculate the amount of charge $C_{rem}$ which is removed from the battery assembly (20, 22) and wherein the state of charge *SOC* reached in said discharging mode is determined according to the formula $SOC = \dfrac{\left(1 - \frac{C_{rem}}{C_{tot}}\right) \cdot 100\%}{}$, where $C_{tot}$ is the total capacity of a fully charged battery assembly (20, 22), that corresponds to the normalized discharge current rate with which the battery assembly (20, 22) is discharged.

8. Method according to claim 7, wherein for the Coulomb counting method the extracted charge $C_{rem}$ from the battery assembly (20, 22) is calculated according to the formula

$$C_{rem} = I_d \cdot \Delta t,$$

where

$I_d$ - is the measured discharge current; and
$\Delta t$ - is the discharge time between two samples of measurements.

9. Method according to claim 8, wherein the time $\Delta t$ will be kept so small such that in this period the discharge current change is insignificant.

10. Method according to claim 9, wherein the battery assembly is periodically put into a maintenance mode in which the step of determining the correspondence between the dependency of the state of charge of the battery assembly to the stable open-circuit voltage of said battery assembly (20, 22) is repeated.

11. Apparatus for estimating the state of charge of a battery assembly, comprising at least one battery assembly (20, 22), one load resistor (30) and at least one voltmeter (60, 62) and an ammeter (70), further comprising one or more controllable switching elements (40, 42) and a microcontroller (10), said microcontroller (10) being adapted to perform data logging for measurement samples of the battery voltages and the discharge currents $I_d$, to count time values $\Delta t$ and to control the one or more switching elements (40, 42) to switch the battery assembly (20, 22) in either the discharging mode respectively charging mode or resting mode, and estimate the state of charge of said at least one battery assembly (20, 22) according to the method according to one of the previous claims.

12. Apparatus according to claim 11, wherein the apparatus comprises two battery assemblies, wherein said microcontroller (10) is adapted to control said one or more switching elements (40, 42) in such a manner, that one battery assembly (20, 22) is put into resting mode while the other battery assembly (20, 22) is put into charging or discharging mode.

13. Apparatus according to claim 11 or 12, wherein the at least one battery assembly (20, 22) comprises one or more valve regulated lead-acid batteries VRLA or one or more vented lead acid batteries.

14. Computer program comprising program code which when run in a computing system performs the method steps according to the method of any one of the claims 1 to 10.

**Patentansprüche**

1. Verfahren zum Schätzen des Ladezustands einer Batteriebaugruppe (20, 22), umfassend die Schritte

   - Bestimmen der Übereinstimmung zwischen der Abhängigkeit des Ladezustands einer Batteriebaugruppe (20, 22) und der Leerlaufspannung der Batteriebaugruppe (20, 22) in einer Trainingsphase für eine Vielzahl unterschiedlicher Entladeströme,
   - Durchführen eines Schritts zum Bestimmen einer Best-Fit-Linie mit der Vielzahl von Datensätzen, die während der Trainingsphase erfasst wurden,

   - Überwachen der Steigung einer Spannungserholungskurve in einer Ruhephase der Batteriebaugruppe (20, 22), in der die Batteriebaugruppe weder in einen Entlademodus noch in einen Lademodus versetzt wird, und Überprüfen, ob die Steigung der Spannungserholungskurve unter einem vordefinierten Grenzwert liegt,
   - Schätzen des Ladezustands der Batteriebaugruppe (20, 22) durch Addieren eines festen Spannungswerts $\Delta U$ zu der für den Zeitpunkt $t1$ gemessenen momentanen Leerlaufspannung $U_{t1}$, für die festgestellt wurde, dass die Steigung der Spannungserholungskurve unter dem vordefinierten Grenzwert liegt; wobei der feste Spannungswert $\Delta U$ aus der Trainingsphase übernommen wird, um die stabile Leerlaufspannung $U_{t1}$, und durch Nachschlagen den entsprechenden Ladezustand in der Best-Fit-Linie mit der resultierenden stabilen Leerlaufspannung zu erhalten.

2. Verfahren nach Anspruch 1, wobei der Schritt zum Bestimmen der Übereinstimmung zwischen der Abhängigkeit des Ladezustands einer Batteriebaugruppe (20, 22) und der Leerlaufspannung der Batteriebaugruppe (20, 22) mehrmals in der Trainingsphase wiederholt wird und wobei für die Vielzahl von Sätzen von Messproben eine Best-Fit-Linie in Form einer linearen Regressionslinie bestimmt wird.

3. Verfahren nach Anspruch 1 oder 2, wobei der Schritt zum Bestimmen der Übereinstimmung in einem Ruhemodus durchgeführt wird, in dem die Batteriebaugruppe (20, 22) weder in einen Entlademodus noch in einen Lademodus versetzt wird.

4. Verfahren nach Anspruch 3, wobei für den Fall, dass der Ruhemodus unterbrochen wird, bevor der Schritt zum Bestimmen der Übereinstimmung zwischen der Abhängigkeit des Ladezustands und der Leerlaufspannung abgeschlossen ist, der Schritt zum Bestimmen der Übereinstimmung in einem folgenden Ruhemodus wiederholt wird.

5. Verfahren nach Anspruch 3, wobei zwei oder mehr Batteriebaugruppen (20, 22) vorgesehen sind und wobei zwischen den Batteriebaugruppen (20, 22) umgeschaltet wird, so dass während eine Batteriebaugruppe (20, 22) in den Entlademodus oder Lademodus versetzt wird, die eine oder mehreren anderen Batteriebaugruppen (20, 22) in den Ruhemodus versetzt werden, in dem die Schritte zum Bestimmen der Übereinstimmung, Überwachen der Steigung einer Spannungserholungskurve und Schätzen des Ladezustands durchgeführt werden.

6. Verfahren nach einem der vorstehenden Ansprüche, wobei die stabile Leerlaufspannung für die Batteriebaugruppe (20, 22) gemäß folgender Formel geschätzt wird

$$OCV = U_{t1} + \Delta U, \text{mit } \Delta U = U_{t_{ocv}} - U_{t1},$$

wobei

OCV die geschätzte stabile Leerlaufspannung ist,
$U_{t_{ocv}}$ die Leerlaufspannung ist, die für den gemessenen Wert $U_{t1}$ als endgültige Leerlaufspannung für diese normalisierte Entladestromrate aufgezeichnet wird.

7. Verfahren nach einem der vorstehenden Ansprüche, wobei zum Bestimmen der Übereinstimmung zwischen der Abhängigkeit des Ladezustands der Batteriebaugruppe (20, 22) und der Leerlaufspannung der Batteriebaugruppe (20, 22) die Batteriebaugruppe (20, 22) in einen Entlademodus mit einer Last versetzt wird, die einer bestimmten normalisierten Entladestromrate entspricht, wobei ein Coulomb-Zählverfahren angewendet wird, um die Ladungsmenge $C_{rem}$ zu berechnen, die von der Batteriebaugruppe (20, 22) entfernt wird, und wobei der im Entlademodus erreichte Ladezustand $SOC$ gemäß der Formel $SOC = (1 - \frac{C_{rem}}{C_{tot}}) \cdot 100\%$ bestimmt wird, wobei $C_{tot}$ die Gesamtkapazität einer vollständig geladenen Batteriebaugruppe (20, 22) ist, die der normalisierten Entladestromrate entspricht, mit der die Batteriebaugruppe (20, 22) entladen wird.

8. Verfahren nach Anspruch 7, wobei für das Coulomb-Zählverfahren die der Batteriebaugruppe (20, 22) entnommene Ladung $C_{rem}$ gemäß der Formel berechnet wird

$$C_{rem} = I_d \cdot \Delta_t,$$

wobei

$I_d$ - der gemessene Entladestrom ist; und
$\Delta_t$ - die Entladezeit zwischen zwei Messproben ist.

9. Verfahren nach Anspruch 8, wobei die Zeit $\Delta t$ so klein gehalten wird, dass in diesem Zeitraum die Entladestromänderung unbedeutend ist.

10. Verfahren nach Anspruch 9, wobei die Batteriebaugruppe periodisch in einen Wartungsmodus versetzt wird, in dem der Schritt zum Bestimmen der Übereinstimmung zwischen der Abhängigkeit des Ladezustands der Batteriebaugruppe und der stabilen Leerlaufspannung der Batteriebaugruppe (20, 22) wiederholt wird.

11. Einrichtung zum Schätzen des Ladezustands einer Batteriebaugruppe, umfassend mindestens eine Batteriebaugruppe (20, 22), einen Lastwiderstand (30) und mindestens ein Voltmeter (60, 62) und ein Amperemeter (70), weiter umfassend ein oder mehrere steuerbare Schaltelemente (40, 42) und einen Mikrocontroller (10), wobei der Mikrocontroller (10) dazu ausgelegt ist, eine Datenprotokollierung für Messproben der Batteriespannungen und der Entladeströme $I_d$ durchzuführen, um Zeitwerte $\Delta t$ zu zählen und um das eine oder die mehreren Schaltelemente (40, 42) zu steuern, um die Batteriebaugruppe (20, 22) entweder in den Entlademodus bzw. Lademodus oder Ruhemodus zu schalten, und um den Ladezustand der mindestens einen Batteriebaugruppe (20, 22) nach dem Verfahren nach einem der vorstehenden Ansprüche abzuschätzen.

12. Einrichtung nach Anspruch 11, wobei die Einrichtung zwei Batteriebaugruppen umfasst, wobei der Mikrocontroller (10) dazu ausgelegt ist, das eine oder die mehreren Schaltelemente (40, 42) so zu steuern, dass eine Batteriebaugruppe (20, 22) in den Ruhemodus versetzt wird, während die andere Batteriebaugruppe (20, 22) in den Lade- oder Entlademodus versetzt wird.

13. Einrichtung nach Anspruch 11 oder 12, wobei die mindestens eine Batteriebaugruppe (20, 22) eine oder mehrere ventilgeregelte Blei-Säure-Batterien VRLA oder eine oder mehrere belüftete Blei-Säure-Batterien umfasst.

14. Computerprogramm, das Programmcode umfasst, der, wenn er in einem Rechensystem abläuft, die Verfahrensschritte gemäß dem Verfahren nach einem der Ansprüche 1 bis 10 durchführt.

**Revendications**

1. Procédé d'estimation de l'état de charge d'un ensemble batterie (20, 22), comprenant les étapes consistant à :

   - déterminer la correspondance entre la dépendance de l'état de charge d'un ensemble batterie (20, 22) et la tension en circuit ouvert dudit ensemble batterie (20, 22) dans une phase d'apprentissage pour une pluralité de courants de décharge différents,
   - réaliser une étape de détermination d'une droite de meilleur ajustement avec la pluralité de jeux de données capturés pendant la phase d'apprentissage,

   - surveiller la pente d'une courbe de rétablissement de tension durant une période de repos dudit ensemble batterie (20, 22), où l'ensemble batterie n'est ni mis dans un mode de décharge ni dans un mode de charge et vérifier si la pente de ladite courbe de rétablissement de tension est sous une valeur de limite prédéfinie,
   - estimer l'état de charge de l'ensemble batterie (20, 22) en ajoutant une valeur de tension fixe $\Delta U$ à la tension en circuit ouvert momentanée $U_{t1}$ mesurée pour ledit instant $t1$ pour lequel il a été constaté que la pente de ladite courbe de rétablissement de tension est sous ladite valeur de limite prédéfinie ; dans lequel la valeur de tension fixe $\Delta U$ est extraite de la phase d'apprentissage, pour obtenir la tension en circuit ouvert stable $U_{t1}$ et, en cherchant l'état de charge correspondant dans ladite droite de meilleur ajustement avec la tension en circuit ouvert stable obtenue.

2. Procédé selon la revendication 1, dans lequel l'étape de détermination de la correspondance entre la dépendance de l'état de charge d'un ensemble batterie (20, 22) et la tension en circuit ouvert dudit ensemble batterie (20, 22) est répétée une pluralité de fois dans ladite phase d'apprentissage et dans lequel, pour la pluralité de jeux d'échantillons de mesure, une droite de meilleur ajustement est déterminée, sous la forme d'une ligne de régression linéaire.

3. Procédé selon la revendication 1 ou 2, dans lequel l'étape de détermination de la correspondance est réalisée dans un mode de repos, où l'ensemble batterie (20, 22) n'est mis ni dans un mode de décharge ni dans un mode de charge.

4. Procédé selon la revendication 3, dans lequel, dans le cas où le mode de repos est interrompu avant que l'étape de détermination de la correspondance entre la dépendance de l'état de charge et la tension en circuit ouvert soit finie, l'étape de détermination de la correspondance est répétée dans un mode de repos suivant.

5. Procédé selon la revendication 3, dans lequel deux ensembles batteries (20, 22) ou plus sont prévus et une commutation a lieu entre les ensembles batterie (20, 22), de telle sorte que, alors qu'un ensemble batterie (20, 22) est mis dans le mode de décharge ou mode de charge, les un ou plusieurs autres ensembles batteries (20, 22) sont mis dans ledit mode de repos dans lequel les étapes de détermination de la correspondance, de surveillance de la pente d'une courbe de rétablissement de tension et d'estimation de l'état de charge sont réalisées.

6. Procédé selon l'une quelconque des revendications précédentes, dans lequel la tension en circuit ouvert stable pour l'ensemble batterie (20, 22) est estimée selon la formule

$$OCV = U_{t1} + \Delta U, \text{avec } \Delta U = U_{t_{ocv}} - U_{t1},$$

   où

   OCV est la tension en circuit ouvert stable estimée,
   $U_{t_{ocv}}$ est la tension en circuit ouvert qui est enregistrée pour la valeur $U_{t1}$ mesurée comme étant la tension en circuit ouvert finale pour ce taux de courant de décharge normalisé.

7. Procédé selon l'une quelconque des revendications précédentes, dans lequel pour déterminer la correspondance entre la dépendance de l'état de charge de l'ensemble batterie (20, 22) et la tension en circuit ouvert dudit ensemble batterie (20, 22), ledit ensemble batterie (20, 22) est mis dans un mode de décharge avec une charge électrique qui correspond à un certain taux de courant de décharge normalisé, dans lequel un procédé de comptage de Coulomb est appliqué pour calculer la quantité de charge $C_{rem}$ qui est retirée de l'ensemble batterie (20, 22) et dans lequel l'état de charge *SOC* atteint dans ledit mode de décharge est déterminé selon la formule

$$SOC = (1 - \frac{C_{rem}}{C_{tot}}) \cdot 100\%$$ , où

$C_{tot}$ est la capacité totale d'un ensemble batterie (20, 22) complètement chargé, qui correspond au taux de courant de décharge normalisé avec lequel l'ensemble batterie (20, 22) est déchargé.

8. Procédé selon la revendication 7, dans lequel, pour le procédé de comptage de Coulomb, la charge extraite $C_{rem}$ de l'ensemble batterie (20, 22) est calculée selon la formule

$$C_{rem} = I_d \cdot \Delta_t,$$

où

$I_d$ - est le courant de décharge mesuré ; et
$\Delta_t$ - est le temps de décharge entre deux échantillons de mesures.

9. Procédé selon la revendication 8, dans lequel le temps $\Delta t$ sera maintenu si petit que, pendant cette période, le changement de courant de décharge est insignifiant.

10. Procédé selon la revendication 9, dans lequel l'ensemble batterie est périodiquement mis dans un mode de maintenance dans lequel l'étape de détermination de la correspondance entre la dépendance de l'état de charge de l'ensemble batterie et la tension en circuit ouvert stable dudit ensemble batterie (20, 22) est répétée.

11. Appareil d'estimation de l'état de charge d'un ensemble batterie, comprenant au moins un ensemble batterie (20, 22), une résistance de charge (30) et au moins un voltmètre (60, 62) et un ampèremètre (70), comprenant en outre un ou plusieurs éléments de commutation (40, 42) pouvant être commandés et un micro-dispositif de commande (10), ledit micro-dispositif de commande (10) étant adapté pour réaliser une journalisation de données pour des échantillons de mesure des tensions de batterie et des courants de décharge $I_d$, pour compter des valeurs temporelles $\Delta t$ et pour commander les un ou plusieurs éléments de commutation (40, 42) pour entraîner la commutation de l'ensemble batterie (20, 22) soit dans le mode de décharge respectivement le mode de charge soit le mode de repos, et estimer l'état de charge dudit au moins un ensemble batterie (20, 22) selon le procédé selon l'une des revendications précédentes.

12. Appareil selon la revendication 11, dans lequel l'appareil comprend deux ensembles batteries, dans lequel ledit micro-dispositif de commande (10) est adapté pour commander lesdits un ou plusieurs éléments de commutation (40, 42) d'une manière telle qu'un ensemble batterie (20, 22) est mis dans le mode de repos alors que l'autre ensemble batterie (20, 22) est mis dans le mode de charge ou de décharge.

13. Appareil selon la revendication 11 ou 12, dans lequel le au moins un ensemble batterie (20, 22) comprend une ou plusieurs batteries au plomb-acide régulées par valve VRLA ou une ou plusieurs batteries au plomb-acide ventilées.

14. Programme informatique comprenant un code de programme qui, lorsqu'il est exécuté dans un système informatique, réalise les étapes de procédé selon le procédé de l'une quelconque des revendications 1 à 10.

Fig. 1

Fig. 2

Fig. 3

Fig. 4

Fig. 5

Fig. 6

Fig. 7

Fig. 9

Fig. 8

Fig. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20130110428 A1

- US 2010007309 A1

### Non-patent literature cited in the description

- **HAIYING WANG ; YANG LIU ; HANG FU ; GECHEN LI.** Estimation of State of Charge of Batteries for Electric Vehicles. *International Journal of Control and Automation,* April 2013, vol. 6 (2), 187
- Industrial batteries. VRLA Handbook
- **BARRIE LAWSON.** *State of Charge (SOC) Determination,* 2005, http://www.mpoweruk.com/soc.htm

- *Technical Specification for Valve Regulated Lead-Acid Batteries (VRLA-GEL),* September 2013, http://www.moll-batterien.de/dateien/pdfs/MOLL TechSpez OPzV solar en.pdf
- **BARRIE LAWSON.** *State of Health (SOH) Determination,* 2005, http://www.mpoweruk.com/soh.htm